(19) **Europäisches Patentamt**

**European Patent Office**

**Office européen des brevets**

(11) **EP 0 757 441 B1**

(12) ## EUROPEAN PATENT SPECIFICATION

(45) Date of publication and mention
of the grant of the patent:
**26.06.2002 Bulletin 2002/26**

(51) Int Cl.⁷: **H03K 17/00**, H03K 17/082,
F02P 3/04

(21) Application number: **95830345.5**

(22) Date of filing: **31.07.1995**

(54) **Voltage limiter integrated electronic circuit**

Integrierte Schaltung zur Spannungsbegrenzung

Circuit intégré pour limiter une tension

(84) Designated Contracting States:
**DE FR GB IT**

(43) Date of publication of application:
**05.02.1997 Bulletin 1997/06**

(73) Proprietor: **STMicroelectronics S.r.l.**
**20041 Agrate Brianza (Milano) (IT)**

(72) Inventor: **Palara, Sergio**
**I-95026 Acitrezza, Catania (IT)**

(74) Representative: **Cerbaro, Elena, Dr. et al**
**STUDIO TORTA S.r.l.,**
**Via Viotti, 9**
**10121 Torino (IT)**

(56) References cited:
**EP-A- 0 040 260**       **EP-A- 0 382 906**
**FR-A- 2 186 739**       **FR-A- 2 399 148**
**GB-A- 2 123 635**       **US-A- 4 233 951**
**US-A- 4 291 319**

## EP 0 757 441 B1

**Description**

The present invention relates to an integrated electronic voltage limiting circuit of suitable voltage and especially to protect against overvoltage a switch placed in series with an electrical load connected to a power supply line.

The field of application of the present invention concerns the automobile industry and specifically the field of electronic ignition with discrete components.

As known, in many cases bipolar transistors are used as switches for supply electrical loads in switching with even very high currents.

Particularly when the electrical load is of the inductive type, opening of the switch, i.e. the sudden change from a conduction state to an interdiction state of the transistor causes a transient overvoltage condition at its ends.

This overvoltage can even be several times greater than the supply voltage and can reach values and durations such as to exceed the safety limits set by the structural characteristics of the transistor and even destroy it.

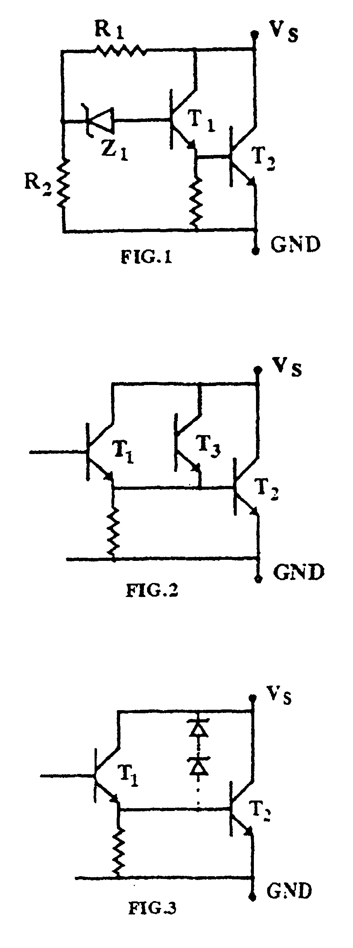

A first technical solution of the prior art to obviate this shortcoming calls for the use of a voltage limiting circuit comprising a type NPN Darlington couple (T1,T2) whose drive transistor is indicated by T1 and at whose ends is present a voltage Vs to be limited as shown in FIG. 1.

This voltage limiting circuit also comprises a Zener diode Z1 having an anode terminal connected to a base terminal of the transistor T1 and a cathode terminal connected to an intermediate node A of a resistive divider (R1,R2) at whose ends is present the voltage Vs to be limited. In this case the voltage Vs is limited to a maximum value equal to:

$$Vs = [V(Z1) + 2Vbe] * (R1+R2)/R2$$

where V(Z1) is the breakdown voltage of the diode Z1 and Vbe are the voltages present between the base and emitter terminals respectively of the transistors T1 and T2 incorporated in the Darlington couple (T1,T2).

A second known technical solution, shown in FIG. 2, calls for the use of a voltage limiting circuit comprising a transistor T3 with open base placed between the transistors T1 and T2 of the Darlington couple (T1,T2).

In this second case the voltage Vs is limited to a maximum value equal to:

$$Vs = Vceo(T3) + Vbe(T2)$$

where Vceo is the breakdown voltage between the collector and emitter terminals of the transistor T3 with open base and Vbe is the voltage present between the base and emitter terminals of the transistor T2.

A last known technical solution of the prior art, shown in FIG. 3, requires that in substitution of the transistor T3 the voltage limiting circuit includes a Zener diode chain.

Although advantageous from various viewpoints the above mentioned voltage limiting circuits are of poor precision because their breakdown voltage varies severely with temperature.

The technical problem underlying the present invention is to provide an integrated electronic voltage limiting circuit which would be very accurate as regards its breakdown voltage and independent of temperature.

The technical problem is solved by a circuit of the above mentioned type as defined in the characterizing part of the annexed claims.

The characteristics and advantages of the circuit in accordance with the present invention are set forth in the description of an embodiment thereof given below by way of non-limiting example with reference to the annexed drawings.

In the drawings:

FIG. 1 shows a diagram of an integrated electronic voltage limiting circuit provided in accordance with the prior art,

FIG. 2 shows a second diagram of a circuit provided in accordance with the prior art,

FIG. 3 shows another diagram of a circuit provided in accordance with the prior art,

FIG. 4 shows a basic diagram of an integrated electronic voltage limiting circuit in accordance with the present invention.

FIG. 5 shows a possible embodiment of the diagram shown in FIG. 4,

FIG. 6 shows a possible embodiment of a detail of the circuit diagram shown in FIG. 4,

FIG. 7 shows a circuit diagram of a possible application of the circuit in accordance with the present invention, and

FIG. 8 shows the relationship between two variable magnitudes present in the circuit in accordance with the present invention.

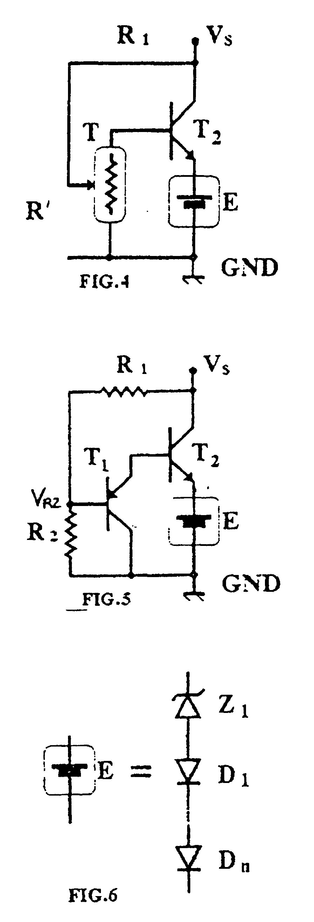

Specifically, with reference to FIG. 4, the voltage limiting circuit comprises at least one first and one second terminal between which is present a voltage Vs to be limited.

The circuit also comprises at least one first bipolar NPN transistor T2 having a first terminal connected to the first terminal of the circuit and a second terminal kept at a reference voltage E.

This first transistor T2 also comprises a control terminal coupled with the second terminal of the circuit through at least one first equivalent resistive element R'.

In FIG. 5 it is seen that the first equivalent resistive element R' incorporates at least one second bipolar PNP transistor T1 having a first terminal connected to the control terminal of the first transistor T2 and a second terminal connected to the second terminal of the circuit.

In addition, the second transistor T1 is equipped with a control terminal driven through a resistive divider (R1,R2) incorporating a second R1 and a third R2 resistive element connected in series together and inserted between the first and second terminals of the circuit.

With reference to FIG. 6 it is seen that the reference voltage E is generated by a plurality of one-way current flow circuit elements (Z1,D1,...Dn) connected together in series.

These circuit elements (Z1,D1,...Dn) comprise at least one Zener diode Z1 with positive temperature coefficient and at least some junction diodes (D1,...Dn) with negative temperature coefficient so as to make the reference voltage E constant with the temperature.

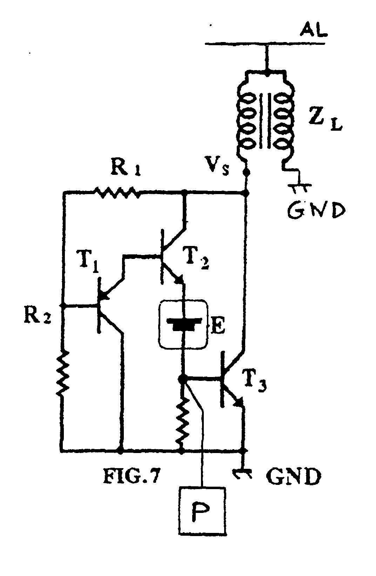

FIG. 7 shows a circuit diagram of a possible application of the circuit.

Specifically the circuit is connected by its first terminal to a first terminal of an inductive electrical load ZL having a second terminal connected to a power supply line AL.

The second terminal of the circuit is connected to a control terminal of a switch T3 placed in series with the electrical load ZL.

The above mentioned control terminal is also connected to drive circuit means P not shown in FIG. 7 because conventional.

It is seen that when the drive circuit means P open the switch T3 provided e.g. through a third bipolar NPN transistor the circuit limits the overvoltage created at the ends of the above mentioned switch.

There is now described operation of the voltage limiting circuit in accordance with the present invention.

It is noted that on the basis of the collector-emitter breakdown characteristic of a bipolar NPN transistor having a resistance between base and emitter the first transistor T2 has a breakdown voltage Vcer greater than the breakdown voltage Vceo present between the first and second terminals of the transistor T2 when the control terminal is open.

This breakdown voltage Vcer is also smaller than the breakdown voltage Vces present between the first and second terminals of the same transistor T2 when the control terminal is short circuited.

In addition, the breakdown voltage Vcer depends on the value of the first equivalent resistive element R'.

Now referring to FIG. 5 it is seen that the reference voltage E is equal to:

$$E = VR2 + VbeT1 - VbeT2$$

where VR2 is the voltage present at the ends of the third resistive element R2, VbeT1 is the voltage present between the first terminal and the control terminal of the second transistor T1 and VbeT2 is the voltage present between the second terminal and the control terminal of the first transistor T2.

When the first transistor T2 is in conduction state we have:

$$Vs = VR2 * (R1+R2)/R2 \qquad (1)$$

If in a first approximation it is assumed that:

$$E = VR2$$

from the formula (1) it is inferred that the reference voltage E and the resistive divider (R1,R2) are temperature constant, the voltage Vs will also be temperature constant.

In this application it is assumed that the first transistor T2 has a voltage Vceo=350V and a voltage Vces=800V.

It is also assumed that the reference voltage E is 20V and the second R1 and third R2 resistive elements are 95kΩ and 5kΩ respectively.

In addition, to the circuit is applied a voltage Vs of increasing value.

Now referring to FIGS. 4 and 5 it is seen that the first equivalent resistive element R' is equal to:

$$R' = E*R1*R2/\{(h_{fe}*(R1*R2)*[E-Vs*R2/(R1+R2)]\} \qquad (2)$$

where $h_{fe}$ is the current gain of the second transistor T1.

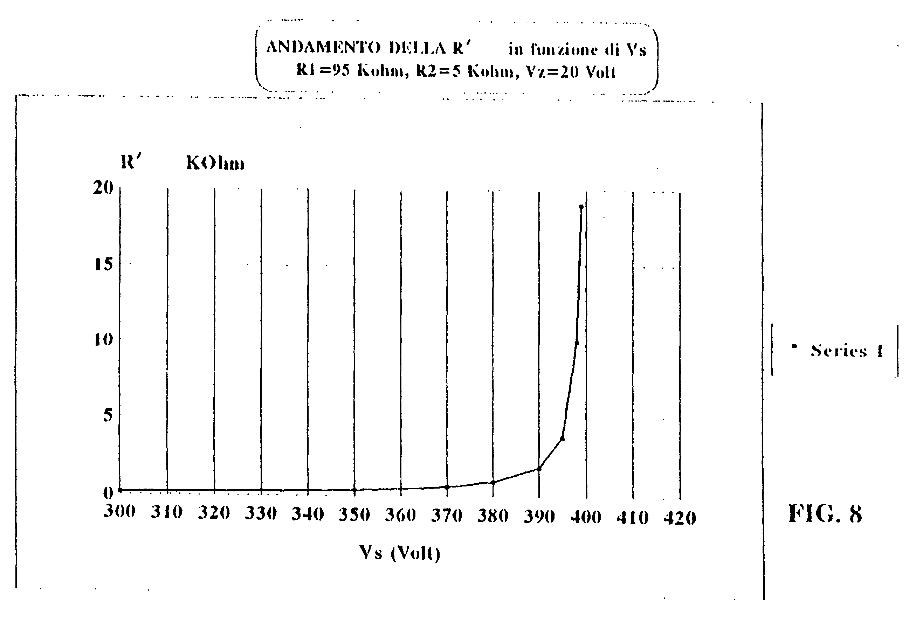

From the above formula it is inferred that for low values of voltage Vs the first resistive element R' has a very low value as shown in the chart represented in FIG. 8.

In this case the first transistor T2 is in a condition near breakdown voltage Vces.

When approaching the condition:

$$E=Vs*R2/(R1+R2) \qquad (3)$$

by substituting this value in the formula (2) it is found that the value of the first resistive element R' tends to infinite.

In this case the first transistor T2 is in a condition near the breakdown voltage Vceo.

Consequently, being placed in the condition

$$Vs>Vceo$$

the first transistor T2 tends to go into breakdown, reducing the voltage at its ends and hence reducing the voltage Vs.

Summing up, the voltage Vs modulates the value of the first resistive element R' in accordance with the formula (2) and the chart shown in FIG. 8 keeping the first transistor T2 in breakdown at a voltage Vs which is taken from the formula (3) and is equal to:

$$Vs_{(Vcer)} = E*(R1+R2)/R2$$

As may be seen, this breakdown voltage is temperature independent as the voltage E is temperature independent.

In conclusion the circuit in accordance with the present invention has a breakdown voltage which is temperature-stable and also of predetermined value between the values of the voltages Vceo and Vces.

## Claims

1. Voltage limiting circuit having a first and a second terminal between which is applied a voltage (Vs) to be limited of the type comprising at least one first transistor (T2) having a first terminal connected to the first terminal of said voltage limiting circuit , a second terminal, and a control terminal coupled with the second terminal of said voltage limiting circuit through at least one first equivalent resistive element (R'), a reference voltage (E) being applied between said second terminal of said first transistor (T2) and said second terminal of said voltage limiting circuit, said reference voltage (E) being temperature independent and said equivalent resistive element (R') having a value depending on the value of the voltage (Vs) to be limited so that the first transistor (T2) will have a temperature-stable breakdown voltage (Vcer).

2. Circuit in accordance with claim 1 and **characterized in that** the first equivalent resistive element (R') comprises at least one second transistor (T1) having a first terminal connected to the control terminal of the first transistor (T2) and a second terminal connected to the second terminal of said voltage limiting circuit .

3. Circuit in accordance with claim 2 and **characterized in that** the second transistor (T1) is equipped with a control terminal driven through a resistive divider (R1,R2) inserted between the first and second terminals of said voltage limiting circuit .

4. Circuit in accordance with claim 3 and **characterized in that** said resistive divider (R1,R2) comprises at least one second (R1) and one third (R2) resistive element connected in series together.

5. Circuit in accordance with claim 1 and **characterized in that** the first transistor (T2) is a bipolar transistor of the NPN type.

6. Circuit in accordance with claim 2 and **characterized in that** the second transistor (T1) is a bipolar transistor of the PNP type.

7. Circuit in accordance with claim 1 and **characterized in that** the reference voltage (E) is generated by at least a plurality of circuit elements with one-way current flow (Z1,D1,...,Dn) connected in series together.

8. Circuit in accordance with claim 7 and **characterized in that** said circuit elements with one-way current flow (Z1,D1,...,Dn) comprise at least one Zener diode with positive temperature coefficient and at least one of the junction diodes with negative temperature coefficient so that the reference voltage (E) is temperature constant.

9. Electronic ignition system for an internal combustion motor of the type comprising:

- an electrical load (ZL) of the inductive type having a first terminal connected to a power supply line (AL) and a second terminal, and

- a switch (T3) inserted with a first and a second terminal between the second terminal of the electrical load (ZL) and a reference potential (GND) and having a control terminal connected to drive circuit means (P);

- at least one voltage limiting circuit connected between the second terminal of the electrical load (ZL) and the control terminal of the switch (T3) to limit an overvoltage present between the first and the second terminals of the switch (T3);

**characterized in that** said circuit comprises a first and a second terminals between which is applied a voltage (Vs) to be limited, said first and second terminals being respectively connected to said second terminal of the electrical load (ZL) and to said control terminal of said switch (T3) and at least one first transistor (T2) having a first terminal connected to the first terminal of the circuit, a second terminal, and a control terminal coupled to the second terminal of the switch (T3) through at least a first equivalent resistive element (R'), a reference voltage (E) being applied between said second terminal of said first transistor (T2) and said second terminal of said voltage limiting circuit, said reference voltage (E) being temperature independent and said equivalent resistive element (R') having a value depending on the value of the voltage (Vs) to le limited so that the first transistor (T2) has a temperature-stable breakdown voltage (Vcer).

**Patentansprüche**

1. Spannungsbegrenzungsschaltung, welche einen ersten und einen zweiten Anschluss aufweist, zwischen welchen eine zu begrenzende Spannung (Vs) angelegt wird, der Ausführung, welche wenigstens einen ersten Transistor (T2) aufweist, welcher einen ersten Anschluss, der mit dem ersten Anschluss der spannungsbegrenzenden Schaltung verbunden ist, einen zweiten Anschluss und einen Steueranschluss aufweist, der mit dem zweiten Anschluss der spannungsbegrenzenden Schaltung über wenigstens ein erstes äquivalentes Widerstandselement (R') verbunden ist, wobei eine Referenzspannung (E) zwischen dem zweiten Anschluss des ersten Transistors (T2) und dem zweiten Anschluss der spannungsbegrenzenden Schaltung angelegt wird, wobei die Referenzspannung (E) temperaturunabhängig ist und das äquivalente Widerstandselement (R') einen Wert besitzt, der von dem Wert der zu begrenzenden Spannung (Vs) abhängt, so dass der erste Transistor eine temperaturstabile Durchbruchsspannung (Vcer) haben wird.

2. Schaltung nach Anspruch 1, **dadurch gekennzeichnet, dass** das erste äquivalente Widerstandselement (R') wenigstens einen zweiten Transistor (T1) beinhaltet, welcher einen ersten Anschluss hat, der mit dem Steueranschluss des ersten Transistors (T2) verbunden ist und einen zweiten Anschluss hat, der mit dem zweiten Anschluss der spannungsbegrenzenden Schaltung verbunden ist.

3. Schaltung nach Anspruch 2, **dadurch gekennzeichnet, dass** der zweite Transistor (T1) mit einem Steueranschluss versehen ist, welcher über einen Widerstandsteiler (R1, R2) gesteuert wird, der zwischen dem ersten und dem zweiten Anschluss der spannungsbegrenzenden Schaltung eingesetzt ist.

4. Schaltung nach Anspruch 3, **dadurch gekennzeichnet, dass** der Widerstandsteiler (R1, R2) wenigstens ein zweites (R1) und ein drittes (R2) Widerstandselement aufweist, welche in Reihe miteinander verbunden sind.

5. Schaltung nach Anspruch 1, **dadurch gekennzeichnet, dass** der erste Transistor (T2) ein bipolarer Transistor vom NPN-Typ ist.

6. Schaltung nach Anspruch 2, **dadurch gekennzeichnet, dass** der zweite Transistor (T1) ein bipolarer Transistor vom PNP-Typ ist.

7. Schaltung nach Anspruch 1, **dadurch gekennzeichnet, dass** die Referenzspannung (E) mit wenigstens einer Vielzahl von Schaltungselementen (Z1, D1,...,Dn) mit Stromfluss in einer Richtung erzeugt wird, welche in Reihe miteinander verbunden sind.

8. Schaltung nach Anspruch 7, **dadurch gekennzeichnet, dass** die Schaltungselemente (Z1, D1,...,Dn) mit Stromfluss in einer Richtung wenigstens eine Zener-Diode mit positivem Temperaturkoeffizienten und wenigstens eine der Sperrschichtdioden mit negativem Temperaturkoeffizienten aufweist, so dass die Referenzspannung (E) temperaturkonstant ist.

9. Elektronisches Zundsystem für einen Verbrennungsmotor von der Art, welches aufweist:

   - eine elektrische Last (ZL) induktiver Art, welche einen ersten Anschluss hat, der mit einer Spannungsversorgungsleitung (AL) und einem zweiten Anschluss verbunden ist, und

   - einen Schalter (T3), welcher mit einem ersten und einem zweiten Anschluss zwischen den zweiten Anschluss der elektrischen Last (ZL) und ein Referenzpotential (GND) eingefügt ist, und welcher einen Steueranschluss hat, der mit der Treiber-Schaltungseinrichtung (P) verbunden ist;

   - wenigstens eine spannungsbegrenzende Schaltung, welche zwischen den zweiten Anschluss der elektrischen Last (ZL) und den Steueranschluss des Schalters (T3) geschaltet ist, um eine Uberspannung zu begrenzen, die zwischen dem ersten und dem zweiten Anschluss des Schalters (T3) vorliegt;

   **dadurch gekennzeichnet, dass** die Schaltung aufweist: einen ersten und einen zweiten Anschluss, zwischen denen eine zu begrenzende Spannung (Vs) angelegt ist, wobei der erste und der zweite Anschluss, jeweils mit dem zweiten Anschluss der elektrischen Last (ZL) und dem Steueranschluss des Schalters (T3) verbunden sind, und wenigstens einen ersten Transistor (T2), welcher einen ersten Anschluss hat, der mit dem ersten Anschluss der Schaltung verbunden ist, einen zweiten Anschluss und einen Steueranschluss hat, der mit dem zweiten Anschluss des Schalters (T3) über wenigstens ein erstes äquivalentes Widerstandselement (R') verbunden ist, wobei eine Referenzspannung (E) zwischen den zweiten Anschluss des ersten Transistors (T2) und den zweiten Anschluss der spannungsbegrenzenden Schaltung angelegt wird, wobei die Referenzspannung (E) temperaturunabhängig ist und das äquivalente Widerstandselement (R') einen Wert besitzt, welcher von dem Wert der zu begrenzenden Spannung (Vs) abhängt, so dass der erste Transistor (T2) eine temperaturstabile Durchbruchsspannung (Vcer) hat.

## Revendications

1. Circuit limiteur de tension ayant une première et une seconde bornes entre lesquelles est appliquée une tension (Vs) à limiter, du type comprenant au moins un premier transistor (T2) ayant une première borne connectée à la première borne dudit circuit limiteur de tension, une seconde borne, et une borne de commande couplée à la seconde borne dudit circuit limiteur de tension par le biais d'au moins un premier élément de résistance équivalent (R'), une tension de référence (E) étant appliquée entre ladite seconde borne dudit transistor (T2) et ladite seconde borne dudit circuit limiteur de tension, ladite tension de référence (E) étant indépendante de la température et ledit élément de résistance (R') ayant une valeur qui est dépendante de la valeur de la tension (Vs) à limiter de sorte que le premier transistor (T2) aura une tension de rupture (Vcer) stable en température.

**2.** Circuit selon la revendication 1 et **caractérisé en ce que** le premier élément de résistance équivalent (R') comprend au moins un second transistor (T1) ayant une première borne connectée à la borne de commande du premier transistor (T2) et une seconde borne connectée à la seconde borne dudit circuit limiteur de tension.

**3.** Circuit selon la revendication 2 et **caractérisé en ce que** le second transistor (T1) est muni d'une borne de commande commandée par un diviseur de résistance (R1,R2) inséré entre les première et seconde bornes dudit circuit limiteur de tension.

**4.** Circuit selon la revendication 3 et **caractérisé en ce que** ledit diviseur de résistance (R1,R2) comprend au moins un second (R1) et un troisième (R2) éléments de résistance montés ensemble en série.

**5.** Circuit selon la revendication 1 et **caractérisé en ce que** le premier transistor (T2) est un transistor bipolaire du type NPN.

**6.** Circuit selon la revendication 2 et **caractérisé en ce que** le second transistor (T1) est un transistor bipolaire du type PNP.

**7.** Circuit selon la revendication 1 et **caractérisé en ce que** la tension de référence (E) est générée par au moins une pluralité d'éléments de circuits avec un flux de courant unidirectionnel (Z1,D1,....,Dn) montés ensemble en série.

**8.** Circuit selon la revendication 7 et **caractérisé en ce que** lesdits éléments de circuit avec un flux de courant unidirectionnel (Z1,D1,....,Dn) comprennent au moins une diode Zener avec un coefficient de température positive et au moins l'une des diodes de jonction avec un coefficient de température négative de sorte que la tension de référence (E) est constante en température.

**9.** Système d'allumage électronique pour un moteur à combustion interne du type comprenant :

- une charge électrique (ZL) du type à induction ayant une première borne connectée à une ligne d'alimentation de puissance (AL) et une seconde borne, et

- un commutateur (T3) inséré avec une première borne et une seconde borne entre la seconde borne de la charge électrique (ZL) et un potentiel de référence (GND) et ayant une borne de commande connectée pour commander les moyens de circuit (P);

- au moins un circuit limiteur de tension connecté entre la seconde borne de la charge électrique (ZL) et la borne de commande du commutateur (T3) pour limiter une surtension présente entre les première et seconde bornes du commutateur (T3);

**caractérisé en ce que** ledit circuit comprend une première borne et une seconde borne entre lesquelles est appliquée une tension (Vs) à limiter, lesdites première et seconde bornes étant respectivement connectées à ladite seconde borne de la charge électrique (ZL) et à ladite borne de commande dudit commutateur (T3) et au moins un premier transistor (T2) ayant une première borne connectée à la première borne du circuit, une seconde borne, et une borne de commande couplée à la seconde borne du commutateur (T3) par au moins un premier élément de résistance équivalent (R'), une tension de référence (E) étant appliquée entre ladite seconde borne dudit premier transistor (T2) et ladite seconde borne dudit circuit limiteur de tension, ladite tension de référence (E) étant indépendante de la température et ledit élément de résistance équivalent (R') ayant une valeur qui est dépendante de la valeur de la tension (Vs) à limiter de sorte que le premier transistor (T2) a une tension de rupture (Vcer) stable en température.

FIG.1

FIG.2

FIG.3

FIG.4

FIG.5

FIG.6

FIG.7

ANDAMENTO DELLA R'    in funzione di Vs
R1 =95 Kohm, R2=5 Kohm, Vz=20 Volt

R'    KOhm

Vs (Volt)

• Series 1

FIG. 8